# EUROPEAN PATENT APPLICATION

(11) **EP 4 474 948 A1**
(43) Date of publication of application: **11.12.2024**
(21) Application number: 24163161.3
(22) Date of filing: 13.03.2024
(51) Int. Cl.: G06F 1/20

(54) **TEMPERATURE ADJUSTMENT MODULE AND TEMPERATURE ADJUSTMENT METHOD**

(30) Priority: 06.06.2023 TW 112121000
(71) Applicant: Giga-Byte Technology Co., Ltd., New Taipei City 231 (TW)
(72) Inventor: KE, Chih-Hua, 231 New Taipei City (TW); CHEN, Hung-Cheng, 231 New Taipei City (TW); LIAO, Tse-Hsien, 231 New Taipei City (TW); CHANG, Ching-Yi, 231 New Taipei City (TW)
(74) Representative: Becker, Eberhard

(57) **Abstract**

A temperature adjustment module (100, 200) and a temperature adjustment method are provided. The temperature adjustment module (100, 200) includes a temperature control module (110, 210, 510, 610, 1011, 1012, 1111, 1112), a temperature changing module (120, 220, 320-340, 520, 620, 720, 820, 920, 1021-1024, 1121-1124), and a temperature sensor (230). The temperature changing module (120, 220, 320-340, 520, 620, 720, 820, 920,1021-1024, 1121-1124) is in contact with a peripheral circuit element (302-304, 501, 601) and electrically connected to the temperature control module (110, 210, 510, 610, 1011, 1012, 1111, 1112). The temperature sensor (230) is in contact with the peripheral circuit element (302-304, 501, 601) and electrically connected to the temperature control module (110, 210, 510, 610, 1011, 1012, 1111, 1112). When a cool down module (310) on a main circuit element (301) of a mother board (300, 500, 1000, 1100) cools down the main circuit element (301), the temperature sensor (230) detects a peripheral temperature of the peripheral circuit element (302-304, 501, 601). The temperature control module (110, 210, 510, 610, 1011, 1012, 1111, 1112) determines whether the peripheral temperature is lower than or higher than a target temperature to determine whether to operate the temperature changing module (120, 220, 320-340, 520, 620, 720, 820, 920,1021-1024, 1121-1124) to perform temperature adjustment on the peripheral circuit element (302-304, 501, 601).

## Description

### BACKGROUND

### Technical Field

The disclosure relates to an adjustment module, and particularly relates to a temperature adjustment module.

### Description of Related Art

Currently, during the process of performing extreme overclocking on a central processing unit (CPU) chip, a graphics processing unit (GPU) chip, and/or a memory module on a computer mother board (MB), liquid nitrogen or liquid helium may be used to cool down the overclocking target element, so that the frequency of the overclocking target element may be increased to an extremely high frequency. Furthermore, during the process of cool down, a peripheral circuit element on the mother board that is adjacent to the overclocking target element may be simultaneously cooled down. In this regard, since an optimal working temperature of the peripheral circuit element may not be extremely low, or insufficient cool down may occur, the operating efficiency of the overclocking target element cannot work normally or efficiently due to the peripheral circuit element, thereby resulting in the actual operating efficiency of the overclocking target element to be unable to achieve a corresponding efficiency improvement effect due to overclocking.

### SUMMARY

The disclosure provides a temperature adjustment module and a temperature adjustment method that may effectively adjust a temperature of a peripheral circuit element on a mother board.

A temperature adjustment module of the disclosure is disposed on a mother board. The temperature adjustment module includes a temperature control module, a temperature changing module, a temperature sensor. The temperature changing module is in contact with a peripheral circuit element and electrically connected to the temperature control module. The temperature sensor is in contact with the peripheral circuit element and electrically connected to the temperature control module. When a cool down module on a main circuit element of the mother board cools down the main circuit element, the temperature sensor detects a peripheral temperature of the peripheral circuit element. The temperature control module determines whether the peripheral temperature is lower than or higher than a target temperature to determine whether to operate the temperature changing module to perform temperature adjustment on the peripheral circuit element.

A temperature adjustment method of the disclosure includes the following steps. When a cool down module on a main circuit element of a motherboard cools down the main circuit element, a peripheral temperature of a peripheral circuit element is detected by a temperature sensor. It is determined whether the peripheral temperature is lower than or higher than a target temperature by a temperature control module to determine whether to operate the temperature changing module to perform temperature adjustment on the peripheral circuit element.

Based on the above, the temperature adjustment module and the temperature adjustment method of the disclosure may perform temperature adjustment on the peripheral circuit element around the main circuit element after the cool down module cools down the main circuit element, so that the main circuit element may operate in good working conditions.

In order to make the features and advantages of the disclosure clearer and easier to understand, the following embodiments are given and described in details with accompanying drawings as follows.

### BRIEF DESCRIPTION OF THE DRAWINGS

FIG. 1 is a schematic circuit diagram of a temperature adjustment module according to an embodiment of the disclosure.
FIG. 2 is a schematic circuit diagram of a temperature adjustment module according to an embodiment of the disclosure.
FIG. 3 is a schematic diagram of a temperature adjustment module disposed on a mother board according to an embodiment of the disclosure.
FIG. 4 is a flow chart of a temperature adjustment method according to an embodiment of the disclosure.
FIG. 5 is a schematic diagram of a temperature adjustment module disposed on a mother board according to an embodiment of the disclosure.
FIG. 6 is a schematic diagram of a temperature adjustment module disposed on a mother board according to an embodiment of the disclosure.
FIG. 7 is a schematic distribution diagram of a plurality of temperature changing areas of a temperature changing module according to an embodiment of the disclosure.
FIG. 8 is a schematic distribution diagram of a plurality of temperature changing areas of a temperature changing module according to an embodiment of the disclosure.
FIG. 9 is a schematic distribution diagram of a plurality of temperature changing areas of a temperature changing module according to an embodiment of the disclosure.
FIG. 10 is a schematic configuration diagram of a temperature control module and a temperature adjustment module according to an embodiment of the disclosure.
FIG. 11 is a schematic configuration diagram of a temperature control module and a temperature adjustment module according to an embodiment of the disclosure.

### DESCRIPTION OF THE EMBODIMENTS

In order to make the content of the disclosure easier to understand, the following specific embodiments are illustrated as examples of the actual implementation of the disclosure. In addition, wherever possible, elements/components/steps with the same reference numerals in the drawings and embodiments represent the same or similar parts.

A main circuit element described in various embodiments of the disclosure may include at least one of a central processing unit (CPU) chip, a graphics processing unit (GPU) chip, and a memory module installed on a computer mother board (MB). The memory module may be, for example, double data rate synchronous dynamic random access memory (DDR SDRAM). A peripheral circuit element described in various embodiments of the disclosure may include a circuit element disposed around the main circuit element, such as a resistor, a capacitor, an inductor, a transistor, a power stage circuit, other functional chips and/or a related circuit wiring, etc.

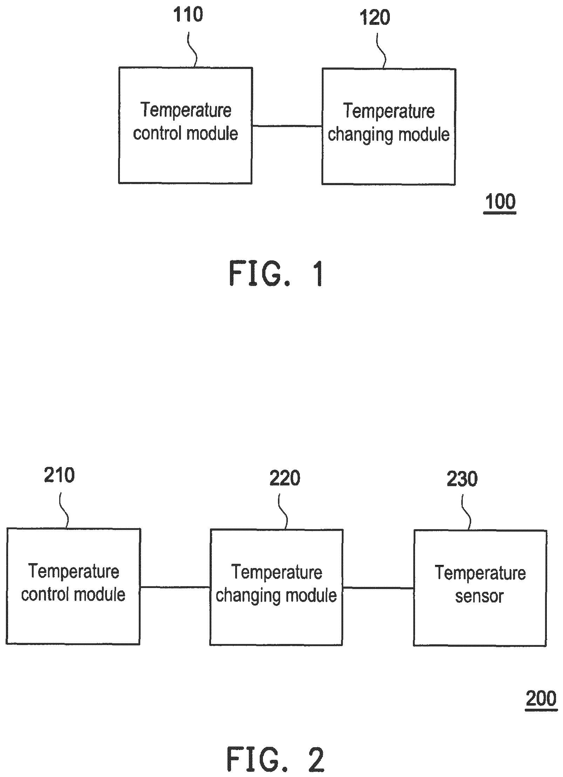

FIG. 1 is a schematic circuit diagram of a temperature adjustment module according to an embodiment of the disclosure. Referring to FIG. 1, a temperature adjustment module 100 includes a temperature control module 110 and a temperature changing module 120. The temperature control module 110 is electrically connected to the temperature changing module 120. In the embodiment, the temperature adjustment module 100 is configured to be disposed on the mother board and configured to perform temperature adjustment on the peripheral circuit element. Specifically, the temperature changing module 120 may include a temperature changing area, and the temperature changing module 120 may be in contact with the peripheral circuit element through the temperature changing area and a heat conduction material. The heat conduction material may be, for example, a thermal paste or a related thermal interface material. In the embodiment, the temperature control module 110 may be configured to control the temperature of the temperature changing module 120 to reach the target temperature. In other words, the temperature control module 110 may directly adjust the temperature of the peripheral circuit element through the temperature changing module 120.

It should be noted that the temperature changing area provided in various embodiments of the disclosure may include a printed circuit board (PCB). The temperature changing module provided in various embodiments of the disclosure may produce temperature changes through the winding wire on the printed circuit board (for example, increasing the voltage or current on the winding wire), or produce temperature changes through the temperature-variable electronic component on the printed circuit board (such as a thermistor, a thermocouple, a thermal resistor, etc.), or simultaneously produce temperature changes through the winding wire on the printed circuit board and the temperature-variable electronic component, so as to achieve the function of changing (or affecting) the temperature of the peripheral electronic element in contact with it. Furthermore, the temperature changing area provided in various embodiments of the disclosure may be a temperature changing area or may include a plurality of temperature changing areas, and each temperature changing area may have a single temperature sub-temperature changing area or a plurality of sub-temperature changing areas. The temperatures of all temperature changing areas and sub-temperature changing areas may be controlled together or individually.

FIG. 2 is a schematic circuit diagram of a temperature adjustment module according to an embodiment of the disclosure. Referring to FIG. 2, a temperature adjustment module 200 includes a temperature control module 210, a temperature changing module 220, and a temperature sensor 230. The temperature control module 210 is electrically connected to the temperature changing module 220 and the temperature sensor 230. In the embodiment, the temperature adjustment module 200 is configured to be disposed on the mother board and configured to perform temperature adjustment on the peripheral circuit element. Specifically, the temperature changing module 220 may include the temperature changing area, and the temperature changing module 220 may be in contact with the peripheral circuit element through the temperature changing area and the heat conduction material. The temperature sensor 230 may be disposed in the temperature changing area of the temperature changing module 220. In the embodiment, the temperature control module 210 may be configured to detect the peripheral temperature of the peripheral circuit element in contact with the temperature changing area through the temperature sensor 230 in real time, and control the temperature of the temperature changing module 220 accordingly to reach the target temperature according to the peripheral temperature of the peripheral circuit element. In other words, the temperature control module 210 may adjust the temperature of the peripheral circuit element through the temperature changing module 220 according to the peripheral temperature of the peripheral circuit element.

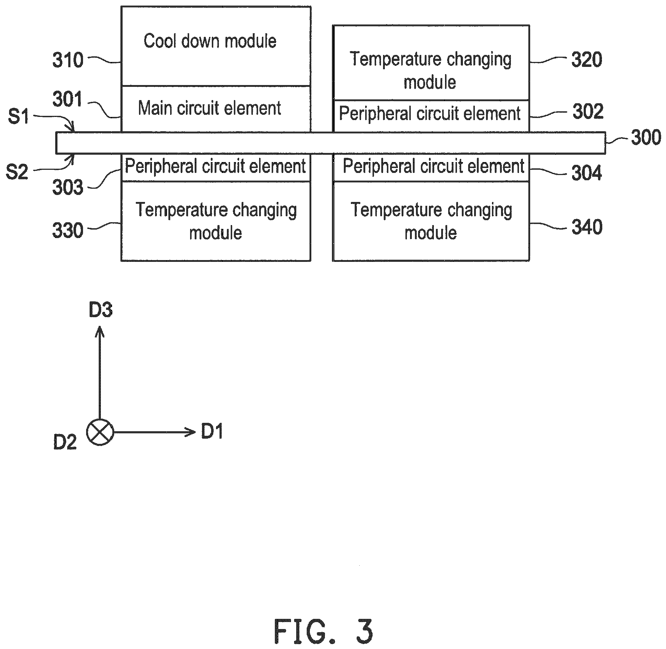

FIG. 3 is a schematic diagram of a temperature adjustment module disposed on a mother board according to an embodiment of the disclosure. Referring to FIG. 3, the arrangement of the temperature changing module provided in various embodiments of the disclosure may be shown in FIG. 3. In the embodiment, a mother board 300 may have a first surface S1 (e.g., a front surface of the mother board) and a second surface S2 (e.g., a back surface of the mother board). The first surface S1 may be parallel to the second surface S2. The first surface S 1 and the second surface S2 may be respectively parallel to planes formed by extending directions D1 and D2 respectively. The direction D1, the direction D2, and a direction D3 are perpendicular to each other. In the embodiment, a main circuit element 301 may be disposed on the first surface S1 of the mother board 300. A peripheral circuit element 302 may be disposed on the first surface S1 of the mother board 300 and adjacent to the periphery of the main circuit element 301. A peripheral circuit element 303 may be disposed on the second surface S2 of the mother board 300 and at a position corresponding to the main circuit element 301 in the direction D3. A peripheral circuit element 304 may be disposed on the second surface S2 of the mother board 300 and adjacent to the periphery corresponding to the position of the main circuit element 301 in the direction D3.

In the embodiment, a cool down module 310 may be disposed on the main circuit element 301. Temperature changing modules 320 to 340 may be disposed on the peripheral circuit elements 302 to 304. In the embodiment, the main circuit element 301 may perform overclocking operation. However, during the process of the overclocking operation performed by the main circuit element 301, the main circuit element 301 itself may heat up. Therefore, in order to ensure that the main circuit element 301 may maintain normal and highly efficient operating functions (such as data processing functions) during the process of the overclocking operation, the cool down module 310 may cool down the main circuit element 301. The cool down module 310 may cool down the main circuit element 301 to a first temperature, and the first temperature may be lower than or equal to the target temperature. In an embodiment, the cool down module 310 may be of, for example, an air-cooling heat dissipation type, a water-cooling heat dissipation type, or an extreme heat dissipation type (for example, using liquid nitrogen or liquid helium).

In particular, the cool down module 310 may be of an extreme heat dissipation type to perform extreme heat dissipation on the main circuit element 301. In this regard, the cool down module 310 may cool down to extremely low temperatures (such as -196°C (liquid nitrogen) or - 267°C (liquid helium)) such that the peripheral circuit elements 302 to 304 are also affected by the cool down. Therefore, in the embodiment, in order to prevent the peripheral circuit elements 302 to 304 from cooling down to a temperature that is too low, which may lead to the peripheral circuit elements 302 to 304 to become disabled or have poor working efficiency (not being at the optimal working temperature), and instead reduce the working efficiency of the main circuit element 301 after overclocking, the temperature changing modules 320 to 340 may heat up the peripheral circuit elements 302 to 304 so as to be at the target temperature (i.e., the optimal working temperature). From another perspective, the main circuit element 301 and the peripheral circuit elements 302 to 304 may have different optimal working temperatures.

Or, in an embodiment, when the optimal working temperature of the peripheral circuit elements 302 to 304 is lower than the current peripheral temperature, the temperature changing modules 320 to 340 may also cool down the peripheral circuit elements 302 to 304. In addition, in another embodiment, the peripheral circuit elements 302 to 304 may have different target temperatures (i.e., optimal working temperatures), or the temperature changing modules 320 to 340 may respectively cool down or heat up the peripheral circuit elements 302 to 304 to different degrees.

In addition, it should be noted that the installation or arrangement positions and quantities of the main circuit element and the peripheral circuit element of the disclosure are not limited to those shown in FIG. 3. FIG. 3 is for illustrative purposes only. The peripheral circuit element referred to in various embodiments of the disclosure may be disposed on the surface of the same side of the same circuit board as the main circuit element. Alternatively, the peripheral circuit element and the main circuit element referred to in various embodiments of the disclosure may be disposed on surfaces on different sides of the same circuit board. Moreover, the peripheral circuit element and the main circuit element may be disposed on different circuit boards.

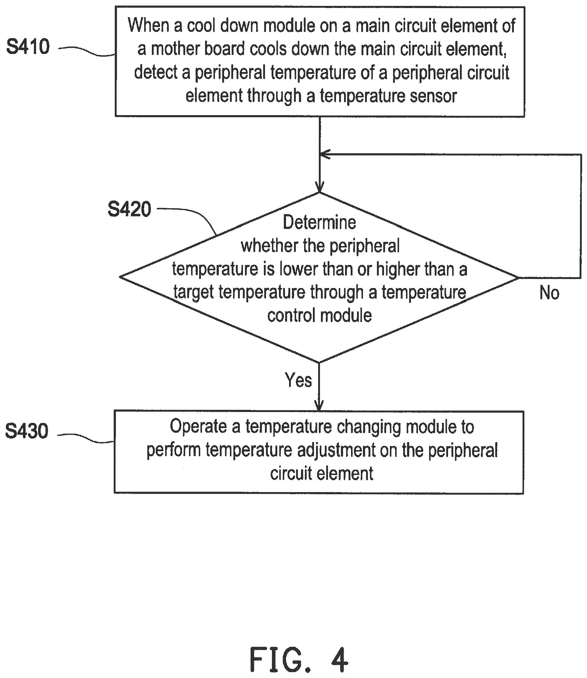

FIG. 4 is a flow chart of a temperature adjustment method according to an embodiment of the disclosure. Referring to FIG. 2 and FIG. 4, the temperature adjustment module 200 of FIG. 2 may perform the following steps S410 to S430. In step S410, when the cool down module on the main circuit element of the mother board cools down the main circuit element, the temperature control module 210 may detect the peripheral temperature of the peripheral circuit element through the temperature sensor 230. In step S420, the temperature control module 210 may determine whether the peripheral temperature is lower than or higher than the target temperature. If not, the temperature control module 210 detects the peripheral temperature of the peripheral circuit element again through the temperature sensor 230 after the preset waiting time, and determines again whether the peripheral temperature is lower than or higher than the target temperature. If so, the temperature control module 210 operates the temperature changing module 220 to perform temperature adjustment on the peripheral circuit element to reach the target temperature. In this regard, when the temperature control module 210 determines that the peripheral temperature is lower than the preset target temperature (i.e., for example, the optimal working temperature of the peripheral circuit element), the temperature control module 210 may operate the temperature changing module 220 to heat up the peripheral circuit element so as to reach the target temperature. Moreover, when the temperature control module 210 determines that the peripheral temperature is higher than the preset target temperature, the temperature control module 210 may operate the temperature changing module 220 to cool down the peripheral circuit element so as to reach the target temperature. In this way, when the main circuit element is in an overclocking operating state, the peripheral circuit element may be maintained at a good (or optimal) working temperature, so that the main circuit element may effectively achieve a highly efficient operation after overclocking when operating together with the peripheral circuit element. In addition, the temperature adjustment method provided in the embodiment may also be applied to the temperature adjustment module 100 of FIG. 1.

Referring again to FIG. 3 for an example, in the embodiment of FIG. 3, a plurality of temperature sensors of the temperature changing modules 320 to 340 may respectively detect a plurality of peripheral temperatures of the peripheral circuit elements 302 to 304, and the temperature control module may individually determine whether temperature adjustment is needed based on the peripheral temperatures. In other words, at least a part of the temperature changing modules 320 to 340 may perform temperature adjustment on the peripheral circuit elements 302 to 304 to varying degrees.

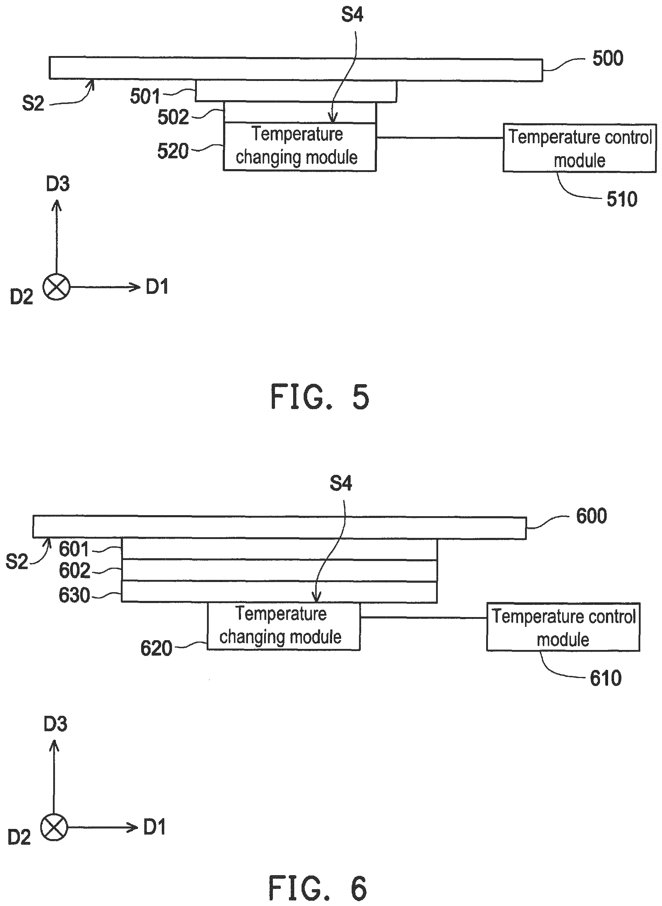

FIG. 5 is a schematic diagram of a temperature adjustment module disposed on a mother board according to an embodiment of the disclosure. Referring to FIG. 5, a peripheral circuit element 501 may be disposed on a surface S2 of a mother board 500. A temperature changing module 520 is disposed on the peripheral circuit element 501, and there is a heat conduction material 502 between the temperature changing module 520 and the peripheral circuit element 501. A temperature control module 510 is electrically connected to the temperature changing module 520. A surface S4 of the temperature changing module 520 may have a temperature changing area. The temperature changing area of the surface S4 of the temperature changing module 520 may be in contact with the peripheral circuit element 501 through the heat conduction material 502, and a temperature sensor may be disposed in the temperature changing area.

In the embodiment, the temperature control module 510 and the temperature changing module 520 may be disposed on different circuit boards. In other words, the temperature control module 510 may be disposed on an external circuit board, and the temperature control module 510 may be electrically connected to the temperature changing module 520 and the temperature sensor through a connection line. Alternatively, in an embodiment, the temperature control module 510 and the temperature changing module 520 may also be disposed (integrated) on the same circuit board.

FIG. 6 is a schematic diagram of a temperature adjustment module disposed on a mother board according to an embodiment of the disclosure. Referring to FIG. 6, a peripheral circuit element 601 may be disposed on a surface S2 of a mother board 600. A temperature adjustment module provided in the embodiment may also include a metal thermostat 630. A metal thermostat 630 is disposed on the peripheral circuit element 601, and there is a heat conduction material 602 between the metal thermostat 630 and the peripheral circuit element 601. A temperature control module 610 is electrically connected to a temperature changing module 620. A surface S4 of the temperature changing module 620 may have a temperature changing area. The temperature changing area of the surface S4 of the temperature changing module 620 may be in contact with the peripheral circuit element 601 through the metal thermostat 630 and the heat conduction material 602, and a temperature sensor may be disposed in the temperature changing area.

In the embodiment, the metal thermostat 630 is disposed between the temperature changing module 620 and the peripheral circuit element 601. The contact area between the metal thermostat 630 and the peripheral circuit element 601 through the heat conduction material 602 is greater than the contact area between the metal thermostat 630 and the temperature changing module 620. In other words, the temperature changing module 620 provided in the embodiment may increase the contact area for temperature change through the metal thermostat 630, and may cover more components or a larger area of the peripheral circuit element 601.

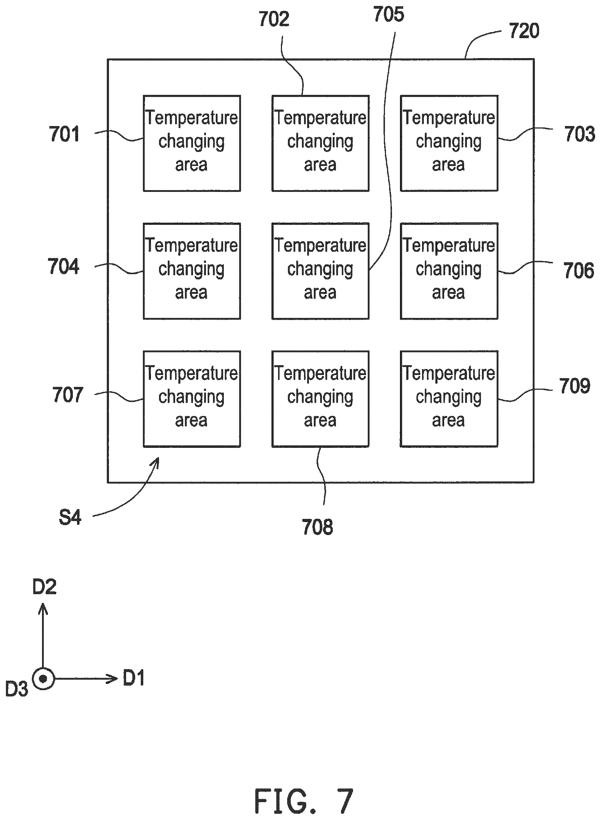

FIG. 7 is a schematic distribution diagram of a plurality of temperature changing areas of a temperature changing module according to an embodiment of the disclosure. A temperature changing module 720 provided in the embodiment may be adapted for performing temperature adjustment on a plurality of peripheral circuit elements in a plurality of sub-areas of a back surface area of a mother board where the CPU chip is disposed. Referring to FIG. 7, a surface S4 of the temperature changing module 720 may include a plurality of temperature changing areas 701 to 709. The temperature changing areas 701 to 709 may be arranged in an array, for example, but the disclosure is not limited thereto. The temperature changing areas 701 to 709 may be in contact with the plurality of peripheral circuit elements through a heat conduction material (or further through a plurality of metal thermostats), and a plurality of temperature sensors may be respectively disposed in the temperature changing areas 701 to 709. In an embodiment, at least a part of the temperature changing areas 701 to 709 may correspond to different target temperatures.

Specifically, in the embodiment, the temperature changing module 720 may be installed on the mother board on the back surface of the CPU chip socket of the mother board. Since the back surface of the CPU chip socket of the mother board is not a flat surface, the heat conduction material may be provided between the temperature changing module 720 and the back surface of the mother board, and the temperature changing module 720 may be fixed to the back surface of the CPU chip socket of the mother board. Each of the temperature changing areas 701 to 709 may be disposed with a temperature sensor. In the embodiment, the temperature changing area 705 may be, for example, directly facing the front and back surface areas of the CPU chip socket of the mother board. During extreme overclocking, the CPU chip may be cooled down through liquid nitrogen, so that the temperature of the temperature changing area 705 may be the lowest temperature relative to the other temperature changing areas. Therefore, the temperature changing area 705 may correspond to a lower or a higher specific target temperature. Moreover, the remaining temperature changing areas 701 to 704 and 706 to 709 may be designed to correspond to different target temperatures based on factors such as having different relative positions to the temperature changing area 705, different electronic components of the mother board, or different layout and wiring.

In the embodiment, assuming that the temperature changing areas 701, 702, 703, 706, and 709 correspond to the position of the power circuit of the CPU chip of the mother board, during extreme overclocking, the temperatures of the temperature changing areas 701, 702, 703, 706, and 709 may be relatively high. Therefore, a plurality of target temperatures of the temperature changing areas 701, 702, 703, 706, and 709 may be, for example, 0 degrees or more, so as to ensure that the mother board and the electronic component are insusceptible to freezing due to the low temperature, and also prevent the mother board from being damaged by liquid water after the ice melts.

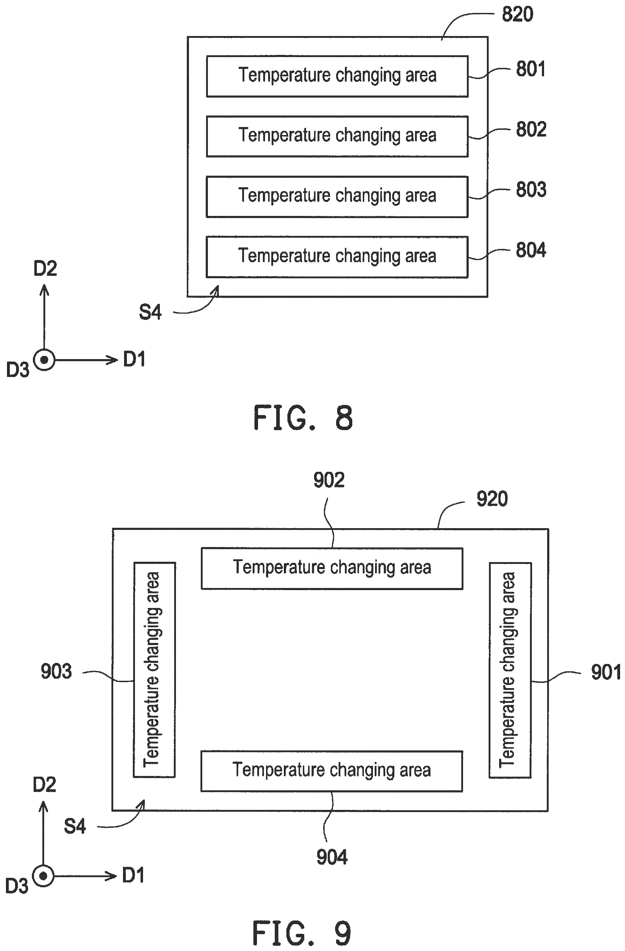

FIG. 8 is a schematic distribution diagram of a plurality of temperature changing areas of a temperature changing module according to an embodiment of the disclosure. A temperature changing module 820 provided in the embodiment may be adapted for performing temperature adjustment on a plurality of peripheral circuit elements in a plurality of sub-areas of a back surface area of a mother board where the memory module is disposed. Referring to FIG. 8, a surface S4 of the temperature changing module 820 may include a plurality of temperature changing areas 801 to 804. The temperature changing areas 801 to 804 may be arranged in a direction D2, for example, but the disclosure is not limited thereto. The temperature changing areas 801 to 804 may be in contact with the plurality of peripheral circuit elements through a heat conduction material (or further through a plurality of metal thermostats), and a plurality of temperature sensors may be respectively disposed in the temperature changing areas 801 to 804. In an embodiment, at least a part of the temperature changing areas 801 to 804 may correspond to different target temperatures.

Specifically, in the embodiment, the temperature changing module 820 may be disposed on the mother board on the back surface of the memory module socket of the mother board. Since the back surface of the memory module socket of the mother board is not a flat surface, the heat conduction material may be provided between the temperature changing module 820 and the back surface of the mother board, and the temperature changing module 820 may be fixed to the back surface of the memory module socket of the mother board. Each of the temperature changing areas 801 to 804 may be provided with two temperature sensors. In the embodiment, the temperature changing areas 801 and 802 may be, for example, directly facing the front and back surface areas of the memory module socket of the mother board. During extreme overclocking, the memory module may be cooled down through liquid nitrogen, so that the temperature of the temperature changing areas 801 and 802 may be the lowest temperature relative to other temperature changing areas. Therefore, the temperature of the temperature changing areas 801 and 802 may correspond to a lower or a higher specific target temperature. Moreover, the remaining temperature changing areas 803 and 804 may be designed to correspond to different target temperatures based on factors such as having different relative positions to the temperature changing areas 801 and 802, different electronic components of the mother board, or different layout and wiring.

In the embodiment, assuming that the temperature changing areas 803 and 804 correspond to the position of the power circuit or the position of the function button of the memory module of the mother board, during extreme overclocking, freezing may easily occur at the temperature of the temperature changing areas 803 and 804, causing abnormality in the function button. Therefore, a plurality of target temperatures of the temperature changing areas 803 and 804 may be, for example, 0 degrees or more, so as to ensure that the mother board and the electronic component are insusceptible from freezing due to the low temperature, and also prevent the mother board from being damaged by liquid water after the ice melts.

FIG. 9 is a schematic distribution diagram of a plurality of temperature changing areas of a temperature changing module according to an embodiment of the disclosure. A temperature changing module 920 provided in the embodiment may be adapted for performing temperature adjustment on a plurality of peripheral circuit elements in a plurality of sub-areas of a back surface area or a front surface peripheral area of a mother board where a GPU chip is disposed. Referring to FIG. 9, a surface S4 of the temperature changing module 920 may include a plurality of temperature changing areas 901 to 904. The temperature changing areas 901 to 904 may be arranged in a ring shape, for example, but the disclosure is not limited thereto. The temperature changing areas 901 to 904 may be in contact with the plurality of peripheral circuit elements through a heat conduction material (or further through a plurality of metal thermostats), and a plurality of temperature sensors may be respectively disposed in the temperature changing areas 901 to 904. In an embodiment, at least a part of the temperature changing areas 901 to 904 may correspond to different target temperatures.

Specifically, in the embodiment, the temperature changing module 920 may be disposed on the back surface area of the GPU chip socket of the mother board. Since the back surface area of the GPU chip socket of the mother board is not a flat surface, the heat conduction material may be provided between the temperature changing module 920 and the back surface of the mother board, and the temperature changing module 920 may be fixed to the back surface area of the GPU chip socket of the mother board. Each of the temperature changing areas 901 to 904 may be provided with two temperature sensors. In the embodiment, the temperature changing areas 901 to 903 may be, for example, directly facing the graphics card memory area of the GPU chip. During extreme overclocking, the GPU chip may be cooled down through liquid nitrogen, so that the temperature of the temperature changing areas 901 to 903 may be the lowest temperature relative to other temperature changing areas. Therefore, the temperature changing areas 901 to 903 may correspond to a lower or a higher specific target temperature. Furthermore, the temperature changing area 904 may be designed to correspond to different target temperatures.

In the embodiment, since whether the graphics card memory of the GPU chip operates at the optimal working temperature will seriously affect the performance of the GPU chip after overclocking, and there is a difference between the optimal working temperature of the graphics card memory and the optimal working temperature of the passive component, during extreme overclocking, the target temperature of the temperature changing areas 901 to 903 may be set at room temperature or more, for example, so as to ensure that the mother board and the electronic component are insusceptible to freezing due to the low temperature, and also prevent the mother board from being damaged by liquid water caused by subsequent melting of the ice.

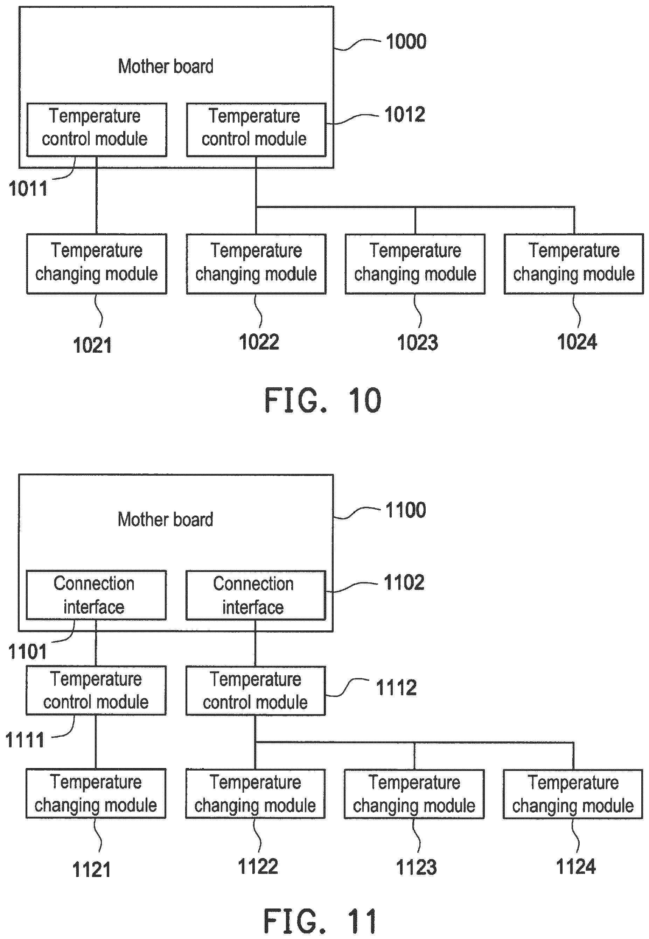

FIG. 10 is a schematic configuration diagram of a temperature control module and a temperature adjustment module according to an embodiment of the disclosure. Referring to FIG. 10, the temperature control module provided in various embodiments of the disclosure may be arranged as described in the embodiment. In the embodiment, temperature control modules 1011 and 1012 may be disposed on a mother board 1000. The temperature control modules 1011 and 1012 may be, for example, a microcontroller unit (MCU) or a control chip. In an embodiment, the temperature control modules 1011 and 1012 may also be implemented through a basic input output system (BIOS) chip or an application program (App) of the operating system (OS).

In the embodiment, the temperature control module 1011 may be electrically connected to the temperature changing module 1021 (and a corresponding temperature sensor) through a dedicated connector and a connection line to control the temperature changing module 1021. The temperature control module 1012 may be electrically connected to a plurality of temperature changing modules 1022 to 1024 (and a corresponding plurality of temperature sensors) through a dedicated connector and a plurality of connection lines to control the temperature changing modules 1022 to 1024. In an embodiment, the temperature control modules 1011 and 1012 may also use hardware circuits to control the temperature changing modules 1021 to 1024 through various switches or jumpers to perform temperature adjustment on the peripheral circuit elements in a plurality of specific areas on the mother board.

In the embodiment, the temperature changing modules 1021 to 1024 may each include a power input interface and be configured to connect to a DC power terminal or interface on the mother board to obtain a power signal. Alternatively, in an embodiment, the temperature changing modules 1021 to 1024 may each obtain the corresponding power signal from the temperature control modules 1011 and 1012 through the corresponding connection line.

FIG. 11 is a schematic configuration diagram of a temperature control module and a temperature adjustment module according to an embodiment of the disclosure. Referring to FIG. 11, the temperature control module provided in various embodiments of the disclosure may be arranged as described in the embodiment. In the embodiment, temperature control modules 1111 and 1112 may be disposed on the same or different external circuit boards. The temperature control modules 1111 and 1112 may be, for example, microcontrollers or control chips.

In the embodiment, the temperature control module 1111 may be electrically connected to a connection interface 1101 (having a specific or dedicated connector) on a mother board 1100 through a connection line, and electrically connected to a temperature changing module 1121 (and a corresponding temperature sensor) through the connection line to control the temperature changing module 1121. The temperature control module 1112 may be electrically connected to a connection interface 1102 (having a specific or dedicated connector) on the mother board 1100 through a connection line, and electrically connected to a plurality of temperature changing modules 1122 to 1124 (and a corresponding plurality of temperature sensors) through a plurality of connection lines to control the temperature changing modules 1122 to 1124. In an embodiment, the temperature control modules 1111 and 1112 may also use hardware circuits to control the temperature changing modules 1121 to 1124 through various switches or jumpers to perform temperature adjustment on the peripheral circuit elements in a plurality of specific areas on the mother board.

To sum up, the temperature adjustment module and temperature adjustment method provided in the disclosure may synchronously adjust the temperature of the peripheral circuit element through the temperature changing module that is in contact with the peripheral circuit element during the extreme cool down process of the main circuit element operating in the overclocking mode, so that the peripheral circuit element may operate at an appropriate temperature, thereby enabling both the main circuit element and the peripheral circuit element to operate at high efficiency state.

## Claims

1. A temperature adjustment module (100, 200), disposed on a mother board (300, 500, 1000, 1100), comprising:
a temperature control module (110, 210, 510, 610, 1011, 1012, 1111, 1112);
a temperature changing module (120, 220, 320-340, 520, 620, 720, 820, 920, 1021-1024, 1121-1124), configured to be in contact with a peripheral circuit element (302-304, 501, 601), and electrically connected to the temperature control module (110, 210, 510, 610, 1011, 1012, 1111, 1112); and
a temperature sensor (230), configured to be in contact with the peripheral circuit element (302-304, 501, 601), and electrically connected to the temperature control module (110, 210, 510, 610, 1011, 1012, 1111, 1112),
wherein when a cool down module (310) on a main circuit element (301) of the mother board (300, 500, 1000, 1100) cools down the main circuit element (301), the temperature sensor (230) detects a peripheral temperature of the peripheral circuit element (302-304, 501, 601),
wherein the temperature control module (110, 210, 510, 610, 1011, 1012, 1111, 1112) determines whether the peripheral temperature is lower than or higher than a target temperature to determine whether to operate the temperature changing module (120, 220, 320-340, 520, 620, 720, 820, 920, 1021-1024, 1121-1124) to perform temperature adjustment on the peripheral circuit element (302-304, 501, 601).

2. The temperature adjustment module (100, 200) according to claim 1, wherein the cool down module (310) cools down the main circuit element (301) to a first temperature, and the first temperature is lower than or equal to the target temperature.

3. The temperature adjustment module (100, 200) according to claim 1, wherein when the temperature control module (110, 210, 510, 610, 1011, 1012, 1111, 1112) determines that the peripheral temperature is lower than the target temperature, the temperature control module (110, 210, 510, 610, 1011, 1012, 1111, 1112) operates the temperature changing module (120, 220, 320-340, 520, 620, 720, 820, 920, 1021-1024, 1121-1124) to heat up the peripheral circuit element (302-304, 501, 601).

4. The temperature adjustment module (100, 200) according to claim 1, wherein when the temperature control module (110, 210, 510, 610, 1011, 1012, 1111, 1112) determines that the peripheral temperature is higher than the target temperature, the temperature control module (110, 210, 510, 610, 1011, 1012, 1111, 1112) operates the temperature changing module (120, 220, 320-340, 520, 620, 720, 820, 920, 1021-1024, 1121-1124) to cool down the peripheral circuit element (302-304, 501, 601).

5. The temperature adjustment module (100, 200) according to claim 1, wherein the temperature changing module (120, 220, 320-340, 520, 620, 720, 820, 920,1021-1024, 1121-1124) comprises:
a temperature changing area (701-709, 801-804, 901-904), configured to be in contact with the peripheral circuit element (302-304, 501, 601) through a heat conduction material (502, 602), wherein the temperature sensor (230) is disposed in the temperature changing area (701-709, 801-804, 901-904).

6. The temperature adjustment module (100, 200) according to claim 1, wherein the temperature changing module (120, 220, 320-340, 520, 620, 720, 820, 920,1021-1024, 1121-1124) comprises:
a plurality of temperature changing areas (701-709, 801-804, 901-904), configured to be in contact with a plurality of peripheral circuit elements (302-304, 501, 601) through a heat conduction material (502, 602), wherein a plurality of temperature sensors (230) are respectively disposed in the temperature changing areas (701-709, 801-804, 901-904).

7. The temperature adjustment module (100, 200) according to claim 6, wherein at least a part of the temperature changing areas (701-709, 801-804, 901-904) correspond to different target temperatures.

8. The temperature adjustment module (100, 200) according to claim 1, wherein the peripheral circuit element (302-304, 501, 601) and the main circuit element (301) are disposed on a same side of a same circuit board.

9. The temperature adjustment module (100, 200) according to claim 1, wherein the peripheral circuit element (302-304, 501, 601) and the main circuit element (301) are disposed on different sides of a same circuit board.

10. The temperature adjustment module (100, 200) according to claim 1, wherein the temperature control module (110, 210, 510, 610, 1011, 1012, 1111, 1112) is disposed on the mother board (300, 500, 1000, 1100), and the temperature control module (110, 210, 510, 610, 1011, 1012, 1111, 1112) is electrically connected to the temperature changing module (120, 220, 320-340, 520, 620, 720, 820, 920, 1021-1024, 1121-1124) and the temperature sensor (230) through a connection line.

11. The temperature adjustment module (100, 200) according to claim 10, wherein the temperature control module (110, 210, 510, 610, 1011, 1012, 1111, 1112) is electrically connected to a plurality of temperature changing modules (120, 220, 320-340, 520, 620, 720, 820, 920, 1021-1024, 1121-1124) and a plurality of temperature sensors (230) through a plurality of connection lines.

12. The temperature adjustment module (100, 200) according to claim 1, wherein the temperature control module (110, 210, 510, 610, 1011, 1012, 1111, 1112) is disposed on an external circuit board, and the temperature control module (110, 210, 510, 610, 1011, 1012, 1111, 1112) is electrically connected to the temperature changing module (120, 220, 320-340, 520, 620, 720, 820, 920, 1021-1024, 1121-1124) and the temperature sensor (230) through a connection line.

13. The temperature adjustment module (100, 200) according to claim 12, wherein the temperature control module (110, 210, 510, 610, 1011, 1012, 1111, 1112) is electrically connected to a plurality of temperature changing modules (120, 220, 320-340, 520, 620, 720, 820, 920, 1021-1024, 1121-1124) and a plurality of temperature sensors (230) through a plurality of connection lines.

14. The temperature adjustment module (100, 200) according to claim 1, wherein the main circuit element (301) performs an overclocking operation.

15. The temperature adjustment module (100, 200) according to claim 1, wherein the main circuit element (301) comprises at least one of a central processing unit chip, a graphics processing unit chip, and a memory module.

16. A temperature adjustment method, comprising:
when a cool down module (310) on a main circuit element (301) of a mother board (300, 500, 1000, 1100) cools down the main circuit element (301), detecting a peripheral temperature of a peripheral circuit element (302-304, 501, 601) through a temperature sensor (230); and
determining whether the peripheral temperature is lower than or higher than a target temperature by a temperature control module (110, 210, 510, 610, 1011, 1012, 1111, 1112) to determine whether to operate a temperature changing module (120, 220, 320-340, 520, 620, 720, 820, 920, 1021-1024, 1121-1124) to perform temperature adjustment on the peripheral circuit element (302-304, 501, 601).

17. The temperature adjustment method according to claim 16, wherein the cool down module (310) cools down the main circuit element (301) to a first temperature, and the first temperature is higher than or equal to the target temperature.

18. The temperature adjustment method according to claim 16, wherein the step of performing temperature adjustment on the peripheral circuit element (302-304, 501, 601) comprises:
when the temperature control module (110, 210, 510, 610, 1011, 1012, 1111, 1112) determines that the peripheral temperature is lower than the target temperature, operating the temperature changing module (120, 220, 320-340, 520, 620, 720, 820, 920,1021-1024, 1121-1124) by the temperature control module (110, 210, 510, 610, 1011, 1012, 1111, 1112) to heat up the peripheral circuit element (302-304, 501, 601).

19. The temperature adjustment method according to claim 16, wherein the step of performing temperature adjustment on the peripheral circuit element (302-304, 501, 601) comprises:
when the temperature control module (110, 210, 510, 610, 1011, 1012, 1111, 1112) determines that the peripheral temperature is higher than the target temperature, operating the temperature changing module (120, 220, 320-340, 520, 620, 720, 820, 920,1021-1024, 1121-1124) by the temperature control module (110, 210, 510, 610, 1011, 1012, 1111, 1112) to cool down the peripheral circuit element (302-304, 501, 601).

20. The temperature adjustment method according to claim 16, further comprising:
performing an overclocking operation on the main circuit element (301).
